Europäisches Patentamt

European Patent Office

Office européen des brevets

(19)

(11) Publication number: 0 113 540
A2

# (12) EUROPEAN PATENT APPLICATION

(21) Application number: 83307405.7

(22) Date of filing: 06.12.83

(51) Int. Cl.³: **H 01 L 29/80**
H 01 L 29/18, H 01 L 29/08
H 01 L 29/60

(30) Priority: 10.12.82 US 448646

(43) Date of publication of application:
18.07.84 Bulletin 84/29

(84) Designated Contracting States:
BE DE FR GB IT NL

(71) Applicant: Western Electric Company, Incorporated
222 Broadway
New York, NY 10038(US)

(72) Inventor: Grabbe, Paul
Apt. 30A Parkview at Madison
Laurence Harbor New Jersey 08879(US)

(72) Inventor: Howard, Richard Edwin
12 McCampbell Road
Holmdel New Jersey 07733(US)

(72) Inventor: Jackel, Lawrence David
31 Stoney Brook Road
Holmdel New Jersey 07733(US)

(72) Inventor: Ko, Ping K.
901 Armstrong Boulevard, Apt. 2B
Ocean New Jersey 07712(US)

(72) Inventor: Swartz, Robert Gerald
J15 Twinlights Terrace
Highlands New Jersey 07732(US)

(74) Representative: Buckley, Christopher Simon
Thirsk et al,
Western Electric Company Limited 5 Mornington Road
Woodford Green Essex IG8 OTU(GB)

(54) Improvements in or relating to semiconductor devices, and methods of making same.

(57) A semiconductor (FET) device includes a channel region (16) of a predetermined doping concentration and thickness so as to form an active pn junction between the gate contact and source region of the semiconductor device. The pn junction creates an active intrinsic junction FET (JFET) which may be pinched off in the operating region of the FET device. The resultant combination is a cascode FET-JFET amplifier arrangement, which comprises operating characteristics of longer gate length devices than the FET device alone, maintaining high saturation output resistance and high d.c. voltage gain.

FIG. 1

EP 0 113 540 A2

- 1 -

(P.Grabbe 1-11-7-1-6)

IMPROVEMENTS IN OR RELATING TO SEMICONDUCTOR DEVICES,
AND METHODS OF MAKING SAME

This invention relates to semiconductor devices and methods of making same.

Integrated circuit technology has been proceeding over the past few years toward faster operating speeds. Increasing the operating speed of MOSFET devices may be increased by reducing the input capacitance associated therewith, where, in particular, the capacitance may be reduced by reducing the MOSFET gate length. However, when the gate length is significantly shortened, undesirable short channel effects, such as reduced output resistance, can occur.

One device capable of reducing some short channel effects, in particular voltage breakdown and threshold variations, is the Lightly Doped Drain-Source (LDD) device developed by IBM Corporation, and described in the article "Design and Characteristics of the Lightly Doped Drain-Source (LDD) Insulated Gate Field-Effect Transistor" by S. Ogura et al appearing in IEEE Transactions on Electron Devices, Vol. ED-27, No. 8, August 1980 at pp. 1359-1367. The LDD structure comprises narrow, self-aligned $n^-$ regions introduced between the channel and the $n^+$ source-drain diffusions of an IGFET to spread the high electric field at the drain pinchoff region and thus reduce the maximum field intensity, thereby increasing the breakdown voltage.

Another device which has been proposed to improve short channel characteristics is the separate gate MOSFET (SG-MOSFET), as described in the article "Submicron Gate MOSFET's with Channel-Doped Separate Gate Structures (SG-MOSFET's)" by K. Yamaguchi et al appearing in IEEE Transactions on Electron Devices, Vol. ED-28, No. 7, July 1981 at pp. 888-890. As disclosed, the Yamaguchi et al device features a buried channel geometry and gate separation from both the source and drain. The SG-MOSFET is intrinsically a depletion mode device under flat band conditions with a conduction path formed between source and drain during the fabrication process. The gate acts to pinch off this conducting channel as increasingly negative voltages are applied thereto. Since the gate does not overlap the source and drain, the gate electrode size is limited only by available lithography techniques.

However, neither of the above-described prior art devices address the short channel problem of reduced voltage gain, which appears in short gate devices due to the reduced output resistance which appears when the device goes into saturation.

According to one aspect of this invention a semiconductor device includes a substrate of a first conductivity type, a source region and a drain region formed in a predetermined spaced-apart relationship to each other in the substrate and being of a second conductivity type opposite the first conductivity type, a source electrode contacting the source region, a drain electrode contacting the drain region, a gate electrode disposed over and isolated from the substrate by a barrier, and a channel for providing a conducting path in the substrate between the source and drain regions, the channel being such as to be capable of creating junction field effect transistor action between the channel the substrate, and the drain region.

According to another aspect of this invention a method of making a semiconductor field effect transistor on a silicon substrate of a first conductivity type includes a. forming a source region and a drain region in a predetermined spaced-apart relationship to each other in the substrate, the source and drain regions being of a second conductivity type opposite the first conductivity type, b. contacting a source electrode to the source region, and a drain electrode to the drain region, c. providing a gate electrode over and isolated from the substrate by a barrier, and d. providing a channel in the substrate for providing a conducting path between the source region and the drain region, the channel being such as to be capable of creating junction field effect transistor action between the channel conductor, the substrate, and the drain region.

The present invention enables the provision of a semiconductor device wherein the channel region is doped in a manner whereby an intrinsic JFET device is created between the channel region and substrate, providing a cascode FET-JFET arrangement capable of operating without reduced output resistance in saturation, thus providing high voltage gain.

The present invention enables the provision of a FET device of short gate length which has operating characteristics of longer gate length devices. The FET and JFET, acting as a cascode amplifier, limit the voltage drop across the FET, thus maintaining the high saturation output resistance characteristic of long-channel devices and providing high d.c. voltage gain.

The present invention permits a reduction in the multiplication of the gate-drain capacitance (Miller-capacitance) by virtue of the existence of the intrinsic JFET.

The invention will now be described by way of example with reference to the accompanying drawings wherein like references denote like parts and in which:

FIGS. 1 and 2 illustrate an n channel depletion mode cascode MOSFET-JFET amplifier embodying the invention;

FIGS. 3 and 4 illustrate an n channel enhancement mode cascode MOSFET-JFET amplifier embodying the invention;

FIGS. 5 and 6 illustrate a p channel depletion mode cascode MOSFET-JFET amplifier embodying the invention;

FIGS. 7 and 8 illustrate a p channel enhancement mode cascode MOSFET-JFET amplifier embodying the invention;

FIGS. 9 and 10 illustrate a CMOS amplifier embodying the invention.

It is to be understood that the present invention is applicable in many semiconductor device structures, including but not limited to, MOSFETs, MESFETs and JFETs, the remaining discussion of the present invention is provided in terms of a MOSFET-JFET cascode arrangement for illustrative purposes only, and is for purposes of exposition and not for purposes of limitation. Further the term "MOSFET" device is deemed to include those devices which comprise a silicon, as well as metal, gate structure.

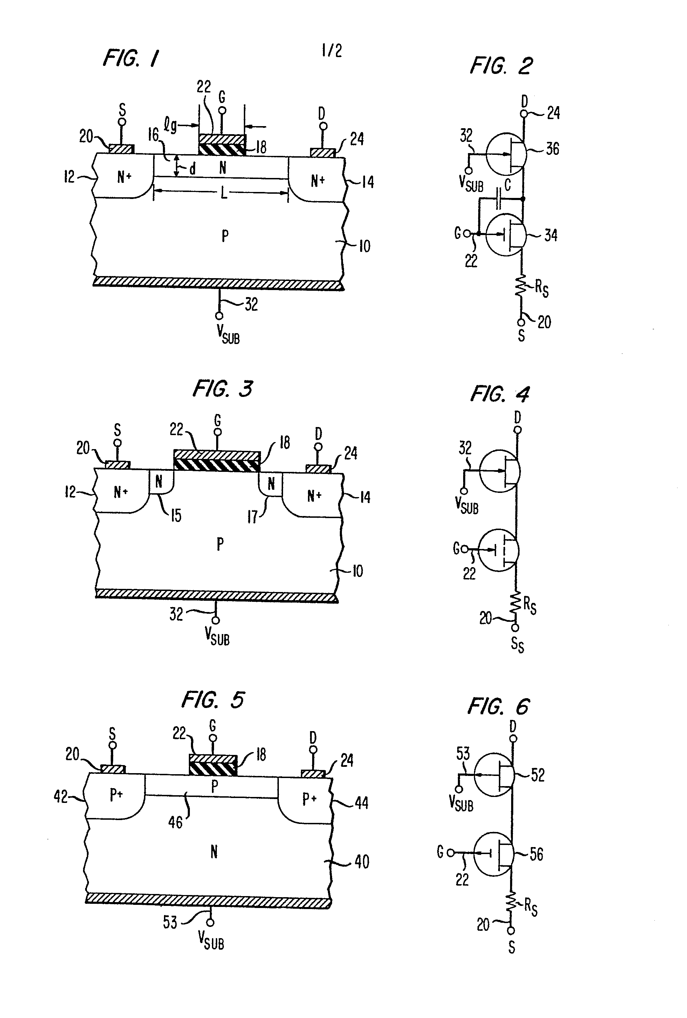

Fig. 1 is a cross-sectional view of an n channel depletion mode short gate MOSFET arrangement. As shown, the device comprises a substrate 10 of p conductivity type, and an $n^+$ conductivity type source region 12 and an $n^+$ conductivity type drain region 14 formed in a spaced-apart relationship in substrate 10. $N^+$ source and drain regions 12 and 14 may be formed in substrate 10 using any of the techniques well-known in the art, for example, optical lithography in combination with etching, ion implantation and thermal processing; such techniques may be employed in forming any embodiment of the present invention discussed hereinafter without any particular reference thereto.

Referring back to FIG. 1, an n channel region 16 is formed in substrate 10 between $n^+$ source region 12 and $n^+$ drain region 14, where as shown in FIG. 1, n channel region 16 comprises a length L and depth $\underline{d}$ into substrate 10. A dielectric layer 18 is disposed over substrate 10, where in the case of MESFET devices, it is known that dielectric layer 18 may be eliminated and a Schottky contact may be employed. A source contact 20 is connected by an ohmic contact to source region 12; likewise, a drain contact 24 is connected by an ohmic contact to drain region 14. A gate contact 22 is disposed on oxide layer 18 over a region of n channel 16, where

the length, $\underline{l}_g$, of gate contact 22 may be made as arbitrarily small as possible; for example, gate lengths of the order of 700A may be obtained using e-beam lithography techniques. However, the gate may overlap both the source and drain regions and still provide the intrinsic JFET action.

As mentioned hereinbefore, there exist prior art devices which include a separate gate structure, that is, a gate contact which does not extend over the drain and source regions of the device. There are many problems which limit the usefulness of these devices, including a low output resistance, $r_0$; the presence of parasitic source and drain channel resistances, $R_S$ and $R_D$, respectively, due to the absence of the gate contact over the entire channel length; and, lastly, the possible occurrence of a large penetration of the substrate/channel depletion layer channel into the substrate, where the depth of this depletion layer is comparable in size to the drain-to-source spacing and is significantly larger than the gate length, thereby resulting in an injection of electrons from the source into the depletion region outside of the channel.

The embodiment illustrated in FIG. 1 is capable of essentially eliminating the above-defined problems, as well as many other problems such as low breakdown voltage, narrow bandwidth, etc., of prior art devices, primarily by the interaction of n channel region 16 with a portion of p substrate 10 located between gate contact 22 and drain contact 24. That is, p substrate 10 and n channel region 16 form a pn junction and cooperate so as to create an intrinsic junction FET (JFET) between n channel region 16, p substrate 10 and $n^+$ drain region 14. It is to be understood that the presence of an active JFET device in the channel region between source region 12 and gate contact 22 is not necessary. In an ideal arrangement, the spacing between the gate and source would be minimized. A predetermined doping concentration and thickness of n channel region 16 is necessary such that n channel region 16 pinches off in the operating range of the device, creating an active JFET device by virtue of the action of the substrate/channel pn junction. In contrast, prior art devices comprise a doping concentration and thickness which creates only a linear resistance, $R_D$, between gate contact 22 and drain contact 24. Therefore, in this embodiment, a cascode MOSFET-JFET amplifier device is formed, where the MOSFET and JFET are in series along the channel. An equivalent circuit of the cascode configuration is illustrated in FIG. 2 which includes a MOSFET 34 and JFET 36, where the above-defined source resistance $R_S$ is included in the channel between gate contact 22 and source contact 20. As mentioned hereinbefore the present invention may be viewed as greatly improving the characteristics of prior art separate gate MOSFET devices by replacing the above-defined linear drain resistance $R_D$ with an active JFET device, thereby significantly improving the operation of the separate gate MOSFET.

In operation, the active components of the complete device act as a cascode amplifier, MOSFET 34 forming the input transistor and JFET 36 forming the output transistor.  In a cascode configuration, the drain-source voltage drop across the input transistor is determined by the output transistor and may be quite small.

JFET 36 is a longer channel device than MOSFET 34 and, therefore, comprises characteristics comparable with prior art long channel devices, for example, a higher output resistance $r_0$ and associated higher d. c. voltage gain.  Thus, even though MOSFET 34 is a short channel device which comprises a low output resistance, as well as other drawbacks of short channel devices, the two devices may be designed to complement each other in such a way that the MOSFET-JFET arrangement act as a longer channel device than the MOSFET alone.  Further, the cascode arrangement lessens the effect of the Miller capacitance, C, which develops between the gate and drain regions in MOSFET devices, thereby improving the operational bandwidth.

In one exemplary fabrication p substrate 10 may comprise a boron-doped silicon wafer of resistivity $3.8\Omega$ cm, and $n^+$ source and drain regions 12 and 14 may be formed by implantation of arsenic ($As^+$) at a dose of $5 \times 10^{15}/cm^2$.  N channel region 16 may comprise an arsenic ($As^+$) implantation at a dose of $7.5 \times 10^{11}/cm^2$ and an additional amount of $B^+$ (boron) implantation with a dose of $2 \times 10^{12}/cm^2$.  Gate oxide layer 18 may be formed to comprise a thickness of 300A. Also, gate length, $l_g$, may range from, for example, $0.08\mu m$ to $>1.6\mu m$.

Another embodiment of the present
invention is illustrated in FIG. 3 which depicts an
n channel enhancement mode cascode MOSFET-JFET in a cross-
sectional view. As compared with the device of FIG. 1, the
device illustrated in FIG. 3 includes a source implant 15
and a drain implant 17 doped so as to form the intrinsic
JFET on the drain side, in place of n channel region 16 of
FIG. 1. As seen in FIG. 3, substrate 10 extends upward
between n source and drain implant regions 15 and 17,
respectively, and when inverted by the field from the gate
becomes the conducting channel for the enhancement mode
device. In a manner similar to the device described
hereinbefore in association with FIG. 1, n drain implant
region 17 and the substrate disposed directly underneath
comprise a doping concentration and thickness capable of
forming an active intrinsic JFET which can then be pinched
off in the operating region of the device JFET. An
equivalent circuit of the cascode device of FIG. 3 is
illustrated in FIG. 4.

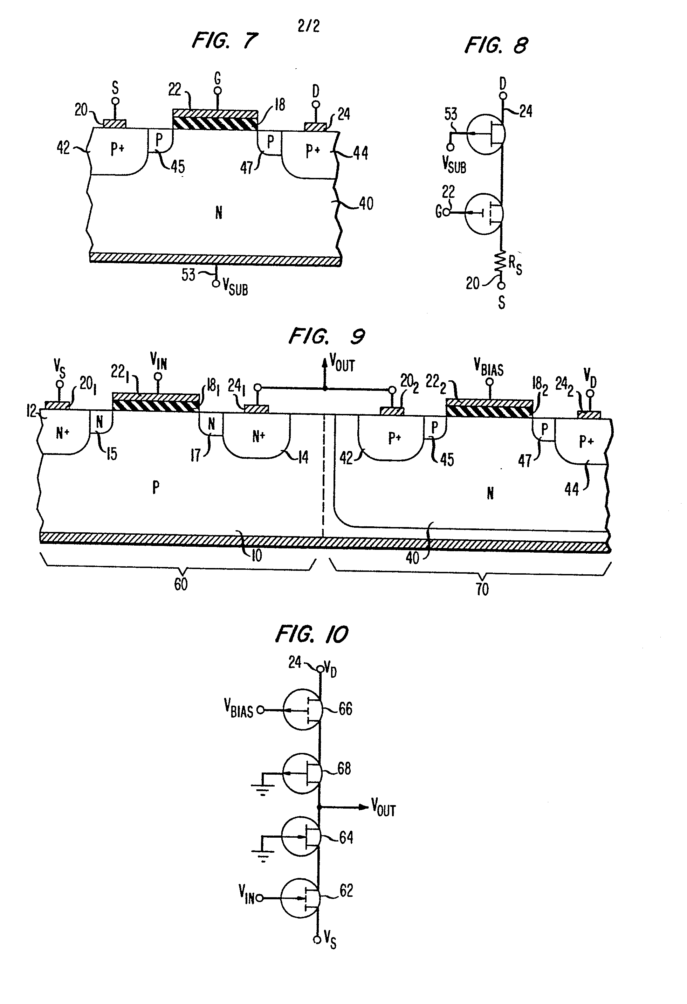

The present invention may also be
constructed as a p-MOS device, a p channel depletion
mode cascode MOSFET-JFET device being
illustrated in FIG. 5, and the
equivalent circuit associated therewith in FIG. 6. As with
the n-MOS devices, a p-MOS enhancement mode device may be
constructed and is
illustrated in FIG. 7, the equivalent circuit being
illustrated in FIG. 8. For both the devices of FIG. 5 and
FIG. 7, a substrate 40 is formed of n type conductivity
material, source and drain regions 42 and 44 are formed in
n substrate 40 and comprise $p^+$ type conductivity material.
Dielectric layer 18, as well as source, gate, and drain
contacts 20, 22 and 24, respectively, are as described
hereinabove with the n-MOS device arrangements.

The depletion mode arrangement of FIG. 5
comprises a p channel region 46 which comprises the necessary doping concentration and thickness so as to interact with n substrate 40 to form a pn junction which creates an active p channel JFET 52. The pn junction forms a "source" input contact of p channel JFET 52, where the gate of JFET 52 is substrate 40 and the drain of JFET 52 is drain contact 24. Thus, as shown in FIG. 6, the device of FIG. 5 forms a cascode MOSFET-JFET arrangement with a p channel depletion mode MOSFET 56 as the input transistor and p channel JFET 52 as the output transistor. The device of FIG. 7 differs from that of FIG. 5 only in its operation as an enhancement mode device, comprising, in lieu of p channel region 46, p source and drain implants 45 and 47, respectively.

As is known in the art, both p-MOS and n-MOS devices may be formed on a single substrate and paired to form a single complementary MOS (CMOS) device. This technology may be applied

to form, as illustrated in FIG. 9, a CMOS amplifier. As shown in FIG. 9, an input (driver) portion 60 of the CMOS amplifier comprises an n channel enhancement mode cascode MOSFET-JFET, as illustrated in FIG. 3, and an output (load) portion 70 of the CMOS amplifier comprises a p channel enhancement mode cascode MOSFET-JFET, as illustrated in FIG. 7. The equivalent circuit of the CMOS amplifier is illustrated in FIG. 10 where, as seen by reference to FIGS. 8 and 9, the input signal to the amplifier is applied to gate contact $22_1$ of n channel MOSFET 62. The output voltage, $V_{out}$, is produced at the junction of drain contact $24_1$ of JFET 64 and source contact $20_2$ of JFET 68. In this circuit, the input capacitance is reduced compared to a conventional CMOS amplifier because of reduction in gate length and gate-drain overlap capacitance for the n channel device. Also, since both n channel driver 60 and p channel load 70 have increased output resistance, higher voltage gains may be expected from a CMOS device embodying the present invention.

CLAIMS

1. A semiconductor device including a substrate (10) of a first conductivity type, a source region (12) and a drain region (14) formed in a predetermined spaced-apart relationship to each other in the substrate and being of a second conductivity type opposite the first conductivity type, a source electrode (20) contacting the source region, a drain electrode (24) contacting the drain region, a gate electrode (22) disposed over and isolated from the substrate by a barrier (18), and CHARACTERIZED BY a channel (16) for providing a conducting path in the substrate between the source and drain regions, the channel being such as to be capable of creating junction field effect transistor action between the channel the substrate, and the drain region.

2. A device as claimed in claim 1, wherein the gate electrode does not cover the source region and the drain region.

3. A device as claimed in claim 1 or 2 wherein the first conductivity type is n type and the second conductivity type is p type.

4. A device as claimed in claim 1 or 2, wherein the first conductivity type is p type and the second conductivity type is n type.

5. A device as claimed in any preceeding claim, wherein the barrier comprises a layer of insulating material.

6. A device as claimed in any one of claims 1 to 4 wherein the barrier is provided by a Schottky contact.

7. A device as claimed in any one of claims 1 to 4 wherein the barrier includes material of the second conductivity type forming a pn junction with the substrate.

8. A device as claimed in claim 1, wherein the channel extends between and is in intimate contact with both the source and drain regions.

9. A device as claimed in any one of claims 1 to 7 wherein the channel includes a source implant (15) in intimate contact with the source region and, spaced apart from the source implant, a drain implant (17) in intimate contact with the drain region.

10. A device as claimed in claim 1 or 2, wherein the substrate comprises a boron-doped silicon material, and the source region, the drain region, and the channel comprise an arsenic-doped material.

11. A device as claimed in any preceding claim and further including a complementary device, the complementary device including a substrate implant (Fig.9,40) of the second conductivity type formed in the substrate next to and spaced apart from the drain region, a second source region (42) and a second drain region (44) of the first conductivity type formed in a predetermined spaced-apart relationship to each other in the substrate implant, a second source electrode ($20_2$) contacting the second source region, a second drain electrode ($24_2$) contacting the second drain region, a second gate electrode ($22_2$) disposed over and isolated from the substrate implant by a second barrier ($18_2$), and a second channel (47) for providing a conducting path in the substrate implant between the second source region and the second drain region the second channel being such as to be capable of creating junction field effect transistor action between the second channel, the substrate implant, and the second drain region, and there being provided means connecting the drain electrode ($24_1$) and the second source electrode ($20_2$) to form a complementary semiconductor device amplifier.

12. A method of making a semiconductor field effect transistor on a silicon substrate (10) of a first conductivity type, including

a. forming a source region (12) and a drain region (14) in a predetermined spaced-apart relationship to each other in the substrate, the source and drain regions being of a second conductivity type opposite the first conductivity type,

b.   contacting a source electrode to the source region, and a drain electrode to the drain region,

c.   providing a gate electrode (22) over and isolated from the substrate by a barrier (18), and CHARACTERIZED BY d.   providing a channel (16) in the substrate for providing a conducting path between the source region and the drain region, the channel being such as to be capable of creating junction field effect transistor action between the channel conductor, the substrate, and the drain region.

13.   A method as claimed in claim 12, wherein in (c) the gate electrode does not overlap either one of both the source drain regions.

14.   A method as claimed in claim 12 or claim 13 wherein the first conductivity type is n type and the second conductivity type is p type.

15.   A method as claimed in claim 12 or 13 wherein the first conductivity type is p type and the second conductivity type is n type.

16.   A method as claimed in claim 12, 13, 14 or 15 wherein in (d) the channel extends between and is in intimate contact with both the source region and the drain region.

17.   A method as claimed in claim 12, 13, 14 or 15 wherein in (d) the channel comprises a drain implant in intimate contact with the drain region and a source implant spaced apart from the drain implant and in intimate contact with the source region.

FIG. 1

FIG. 2

FIG. 3

FIG. 4

FIG. 5

FIG. 6

1/2

0113540

FIG. 7

FIG. 8

FIG. 9

FIG. 10